(19) Europäisches Patentamt

European Patent Office

Office européen des brevets

(11) **EP 0 844 720 B1**

(12) **EUROPÄISCHE PATENTSCHRIFT**

(45) Veröffentlichungstag und Bekanntmachung des Hinweises auf die Patenterteilung:
**17.04.2002 Patentblatt 2002/16**

(51) Int Cl.$^7$: **H02H 7/08**, H03K 17/082

(21) Anmeldenummer: **97115865.4**

(22) Anmeldetag: **12.09.1997**

(54) **Verfahren und Vorrichtung zur Stromüberwachung für Halbleiterschaltungen**

Method and device for current monitoring of semiconductor circuits

Procédé et dispositif pour surveiller le courant de circuits intégrés

(84) Benannte Vertragsstaaten:
**FR GB IT**

(30) Priorität: **23.11.1996 DE 19648562**

(43) Veröffentlichungstag der Anmeldung:
**27.05.1998 Patentblatt 1998/22**

(73) Patentinhaber: **SEMIKRON Elektronik GmbH 90431 Nürnberg (DE)**

(72) Erfinder: **Zametzky, Klaus 90556 Seukendorf (DE)**

(56) Entgegenhaltungen:
**EP-A- 0 315 597          US-A- 4 924 158**

Bemerkungen:
Die Akte enthält technische Angaben, die nach dem Eingang der Anmeldung eingereicht wurden und die nicht in dieser Patentschrift enthalten sind.

**Beschreibung**

Die Erfindung beschreibt ein Verfahren und eine zur Realisierung dieses Verfahrens notwendige Vorrichtung zur Stromüberwachung für Halbleiterbauelemente in Schaltungsanordnungen, insbesondere für Leistungshalbleiterbauelemente nach den Merkmalen des Oberbegriffes des Anspruches 1. Stromüberwachungen, insbesondere zur Überstromüberwachung, sind mehrfach aus der Literatur durch Beschreiben ihrer Anordnungen bekannt.

Die dem Stand der Technik zuordenbaren Vorveröffentlichungen beschränken sich hauptsächlich auf die Verbesserung der Kurzschlußbeständigkeit von Leistungsschaltern. Dabei wird immer von dem geöffneten oder dem geschlossenen Stromkreis des Halbleiterschalters ausgegangen. In DE 44 10 978 A1 wird beispielhaft ein Verfahren und eine dazu vorgestellte Schaltung zur Verbesserung der Kurzschlußfestigkeit eines bipolaren IGBT vorgestellt. Durch Einbinden eines MOSFET in den Gate- Ansteuerkreis wird der Stromfluß im Kurzschlußfall begrenzt.

Mit DE 44 05 482 A1 und EP 0 596 472 A2 sind Schaltungen bekannt, die Überspannungs-Überwachungen beschreiben. Solche Schaltungsvarianten sind für die Lösung der eigenen Aufgabenstellung ungeeignet.

Die dem Stand der Technik entsprechenden Treiber für Halbbrücken- und Vollbrücken-Schaltungen arbeiten mit dem Spannungsabfall über extra vorgesehene Shunt- Widerstände. Das ist insbesondere bei Hochleistungsschaltern unwirtschaftlich, denn dafür geeignete Widerstände sind teuer und die auftretende Verlustleistung muß abgeführt werden, was die Leistungsfähigkeit der Schaltungsanordnung einengt und deren Wirkungsgrad verschlechtert.

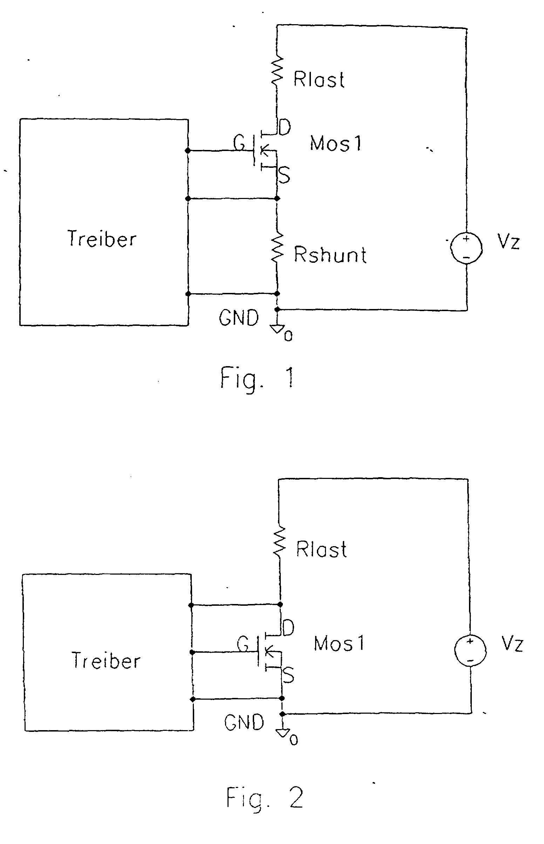

**Fig. 1** zeigt den Stand der Schaltungstechnik. Im Blockschaltbild wird die Ansteuerschaltung eines einzelnen Leistungsschalters mit integrierter Kurzschlußüberwachung dargestellt. Fig. 1 stellt dabei einen Teil aus dem Zusammenhang der Gesamtheit aller parallel oder in Reihe geschalteten weiteren Leistungsschalter der gleichen Art herausgelöst und in gleicher Weise nur den für die Erfindung maßgebenden Teil der Ansteuerung der Gesamtschaltungsanordnung dar.

Die Überwachung des Betriebsstromes des beispielhaft dargestellten MOSFET (MOS1) erfolgt durch die Messung des Spannungsabfalles über den in Reihe geschalteten Widerstand (Rshunt). Dieser Spannungsabfall ist proportional zu dem Stromfluß über dem Leistungsschalter (MOS1). Vz stellt die Gleichstromversorgung (beispielhaft eine Batterie über einen Zwischenkreis) und Rlast den Arbeitswiderstand (z.B. Motorantrieb) dar. Bei Einsatz von mehreren Schaltern in einer Schaltungsanordnung (Halb- oder Vollbrücken) ergeben sich für jeden einzelnen Schalter die erforderlichen Leitungen von den Treibern zu der Steuerelektronik, zudem ist eine relativ aufwendige Auswertung notwendig, da jeder Schalter für sich zu überwachen ist.

Die vorliegende Erfindung hat sich die Aufgabe gestellt, ein Verfahren und zu dessen Realisierung eine einfache und preiswerte Vorrichtung zur Erfassung und Übertragung des Betriebsstromwertes zur Kurzschlußüberwachung einer Schaltungsanordnung vorzustellen.

Die Aufgabe wird bei Schaltungsanordnungen mit Leistungshalbleitern der dargestellten Art durch die Maßnahmen des kennzeichnenden Teiles des Anspruches 1, gelöst, bevorzugte Weiterbildungen werden in den Unteransprüchen beschrieben.

Die erfinderische Lösung wird anhand der Fig. 2 bis 4 erläutert.

**Fig. 2**    zeigt eine Prinzipskizze der Betriebstromüberwachung durch Uds- Erfassung nach dem Stand der Technik.

**Fig. 3**    zeigt ein Prinzipschaltbild einer gesamten Vollbrückenschaltung mit Uds- Erfassung nach dem Stand der Technik.

**Fig. 4**    stellt die erfinderische Lösung der Uds- Überwachung einer gesamten Leistungsschalter-Vollbrücke dar.

**Fig. 2** zeigt eine Prinzipskizze einer Betriebstromüberwachung durch Uds- Erfassung. Vz stellt in dieser Skizze die Stromversorgung über einen Zwischenkreis dar. Bei Einsatz eines IGBT ergibt sich analog eine Uce- Erfassung. Der Zusammenhang zwischen Stromfluß und Spannungsabfall ist durch die Ausgangskennlinie des verwendeten Leistungshalbleiterbauelementes bestimmt.

Übersteigt der Spannungsabfall Uds an MOS 1 in dessen eingeschaltetem Zustand, also seine Flußspannung (Uf von MOS1) einen kritischen Wert, so muß aufgrund der Ausgangskennlinie von MOS1 auch dessen Drainstrom einen kritischen Wert übersteigen (Überstrom). Um in solch einem Falle den MOS1- Schalter zu schützen, schaltet der den MOS1 steuernde Treiber selbständig ab. Eine Auswertung der Uds- Spannungswerte darf nur bei eingeschaltetem Leistungsschalter erfolgen. Für eine entsprechende Logik im Treiber ist zu sorgen, sie muß vorhanden sein.

In sehr vielen Schaltungsanordnungen ist dem Treiber (bzw. sind den Treibern) eine Steuerelektronik überlagert. Der Treiber muß dieser übergeordneten Steuerelektronik einen aufgetretenen Überstrom in Form eines daraus resultierendem Fehlersignals melden, um entsprechend sinnvoll elektronisch reagieren zu können. Bei komplexen Strukturen, wie Halboder Vollbrückenschaltungen, ist der erforderliche Schaltungsaufwand erheblich, da mehrere Treiber zum Einsatz kommen und in jedem Treiber eine Überwachungsschaltung für die Flußspannung des nachgeschalteten Halbleiterschalters mit entsprechender Logik und von jedem Treiber eine Meldeleitung zur Steuerelektronik vorzusehen ist.

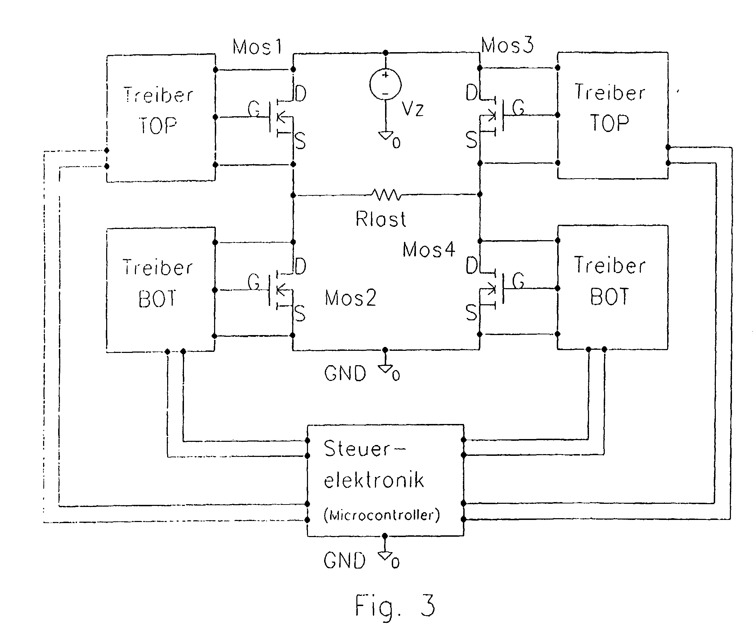

**Fig. 3** zeigt ein Prinzipschaltbild einer gesamten Vollbrückenschaltung mit einer Uds-Erfassung nach dem Stand der Technik, wie er auch aus dem Katalog "SEMIDRIVER" der Firma SEMIKRON von 1/95 auf Seite 2 im Blockschaltbild ersichtlich ist. Über eine Steuerelektronik, in Fig. 3 beispielhaft als Microcontroller skizziert, werden die vier Treiber, je zwei für die TOP- und BOTTOM- Ansteuerung, der vier Leistungsschalter (MOS 1 bis MOS 4) angesteuert. Die Übertragung eines möglichen Fehlersignals der Treiber in BOTTOM-Position kann sehr einfach erfolgen, da diese das gleiche Bezugspotential besitzen, wie die Steuerelektronik. Das Bezugspotential der Treiber in TOP- Position liegt auf dem Source-Potential der Schalttransistoren in TOP- Position und springt bei jedem Schaltvorgang bis auf Zwischenkreisniveau (Vz). Die Überwachungsschaltung im Treiber muß dann mit diesem Potential mitspringen.

Aufwendig ist die Übertragung eines Fehlersignals vom springenden TOP- Bezugsspannungs-Potential auf das ruhende Potential der überlagerten Steuerelektronik des hier skizzierten Microcontrollers. Üblicher Weise geschieht dies induktiv über Signaltransformationen oder durch Optokoppler. Die Stromversorgung der TOP- Treiberstufe kann durch DC/DC- Wandler oder Bootstrapschaltung realisiert werden.

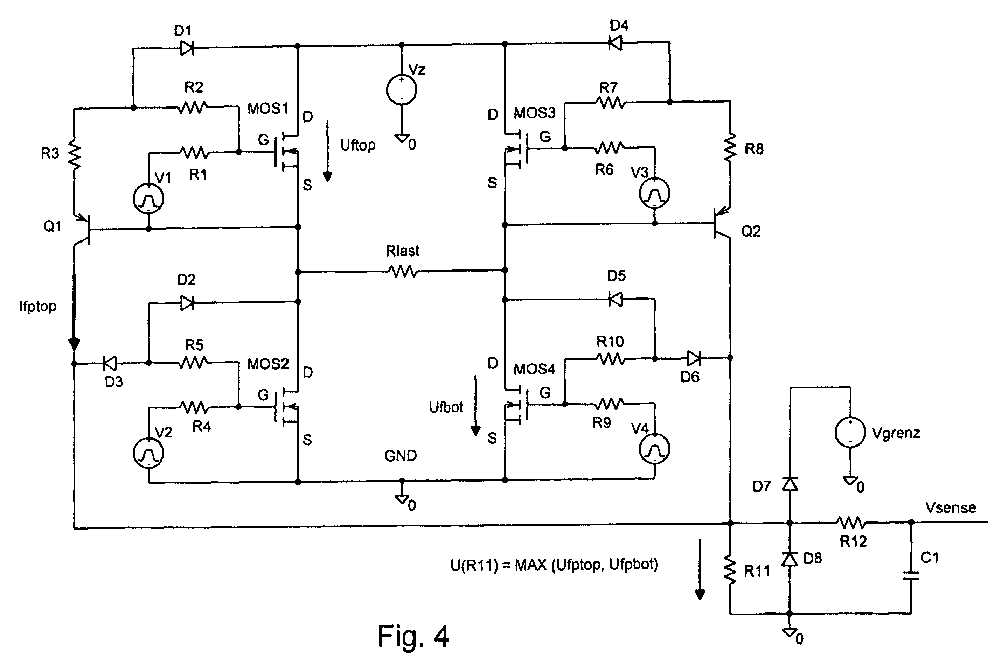

**Fig. 4** skizziert die erfinderische Lösung der Uds- Überwachung am Beispiel einer gesamten Vollbrücke mit Leistungsschaltern. Analog der Fig. 3 sind wiederum vier Leistungsschalter (MOS1 bis MOS4) in der Anordnung zusammengeschaltet. Die Stromversorgung erfolgt aus dem Zwischenkreis (Vz), die Pulsspannungsquellen (V1 bis V4) sind stellvertretend für die Treiberendstufen (zwei in TOP- und zwei in BOTTOM- Position) dargestellt.

Zur Messung der Uds- Spannung des beispielhaft herausgegriffenen TOP- Schalters (MOS 1) nur in dessen eingeschaltetem Zustand ist eine Erweiterung der Beschaltung des TOP-Schalters erforderlich Durch eine Diode (D1), drei Widerstände (R1, R2, R3) und einen bipolaren Transistor (Q1) wird diese Beschaltung realisiert. Wir betrachten den Zeitpunkt, in dem durch den Treiber keine Gate- Source- Spannung (Ugs) an den TOP- Schalter (MOS1) gelegt ist, hier ist V1 = 0 Volt. Der TOP- Schalter (MOS 1) ist ausgeschaltet. Jetzt befinden sich die Diode (D1) und der Transistor (Q1) im Sperrzustand, der Kollektorstrom (von Q1) ist vernachlässigbar klein.

Legt V1 eine Steuerspannung Ugs an MOS1 an, so steuert dieser-nach Erreichen der Einschaltschwelle durch. Zu diesem Zeitpunkt fließt über den Widerstand (R2) ein Strom in die Diode (D1) in Durchlaßrichtung sowie über den Widerstand (R3) in den Emitter des Transistors (Q1). Der Kollektorstrom (Ic von Q1) errechnet sich wie folgt:

**Aus $Ic(Q1) \gg Ib(Q1)$ folgt:**

**$Ic(Q1) = (Uds(MOS1) + Uf(D1) - Ube(Q1)) / R3$**

> Ic = Kollektorstrom; Ib = Basisstrom
>
> Ube = Basis/Emitter- Spannung
>
> Uf = Durchlaßspannung der Diode

Bei gleichartig aus Silizium aufgebauten pn- Übergängen des Transistors(Q1) und der Diode (D1) kompensieren sich die Flußspannungen (Uf), der Diode (D1) und der Basis- Emitter-Strecke (Ube), wie auch bei dem Temperaturgang, daraus folgt:

$$Uf(D1) = Ube(Q1) \qquad und \qquad Ic(Q1) = Uds(MOS1)/R3$$

bei R3 = R11 ergibt sich dann:

**$U(R11) = Uds(MOS1)$**

Der Mechanismus der Leistungsschalter in der BOTTOM- Position (MOSFET2) ist analog:

$$U(R11) + Uf(D3) = Uds(MOS2) + Uf(D2), \qquad mit \qquad Uf(D3) = Uf(D2) \text{ folgt:}$$

**$U(R11) = Uds(MOS2)!$**

Bei Betrieb der gesamten Vollbrücke sind entweder die Leistungstransistoren (MOS 1) und (MOS 4) oder die Leistungstransistoren (MOS 2) und (MOS 3) leitend. Durch die Verschaltung der Kollektoren von Q1 und Q2 mit den Kathoden von D3 und D6 erreicht man eine analoge Disjunktion (analoge Maximalwertbildung) der abgeleiteten Flußspannungen aller Halbleiterschalter, so daß die Spannung über R11 gleich der höchsten Uds- Spannung in der gesamten Schaltung der Vollbrücke ist.

Der schaltungstechnische Aufwand reduziert sich im Vergleich zu Lösungen nach dem Stand der Technik erheblich, da die Uds- Überwachungsschaltung zusammen mit der erfinderischen Logik nur einmal pro Schaltungsanordnung erforderlich ist. Zusätzlich entfällt das Übertragen der Information über die Größe der Flußspannung der Schalter von den Treibern zur Steuerelektronik, was in bekannter Weise besonders für die Treiber in TOP- Positionen sehr aufwendig ist.

Eine Uds- Messung erfolgt nur bei eingeschaltetem Leistungstransistor und durch Kontrolle einer einzigen Spannung wird die gesamte Vollbrücke überwacht. Prinzipiell kann diese erfinderische Schaltungsanordnung auch in Halbbrücken und Einzelschaltern angewandt werden.

Nutzt man nur das Verfahren der Wandlung der Flußspannung eines Halbleiters in TOP-Position in einen dazu proportionalen Strom und Rückwandlung dieses Stromes in eine Spannung auf der BOTTOM- Bezugsspannungs- Potentialebene (GND), so kann auch ein Einzelschalter in TOP- Position allein überwacht werden. Das beinhaltet den Vorteil, daß die Auswerte-/Überwachungsschaltung, welche diese Spannung auf BOTTOM-Bezugsspannungs- Potentialebene verarbeitet, auf eben diesem BOTTOM- Bezugsspannungs-Potential liegen kann

Beim Betrieb der Vollbrücke kann es, bedingt durch Schaltverzögerungen der Leistungshalbleiterschalter oder durch parasitäre Effekte zu Störimpulsen an R11 kommen. Zur Filterung solcher Störungen ist eine dem Stand der Technik entsprechende Schaltung zur Ableitung von Vsense aus U(R11) erforderlich. Diese wird erfindungsgemäß aus nur einer einzigen in Fig. 4 beispielhaft dargestellten Klemm- und Filterschaltung zur Entstörung der gesamten Vollbrücke gebildet, sie besteht aus dem Widerstand R12, den Dioden D7 und D8, der Kapazität C1 sowie der Spannungsquelle Vgrenz.

Die erfinderische Lösung kann neben einer Überstromüberwachung auch zur Erfassung der Schaltstrome herangezogen werden. Der Zusammenhang zwischen Stromfluß (Drain- oder Kollektorstrom) und dem Spannungsabfall (Drain- Source- bzw. Kollektor- Emitter-Spannung) wird bei vielen Halbleiterbauelementen von der Steuerspannung und der Temperatur beeinflußt

Bei den hier dargestellten MOSFET- Schaltern ist der Spannungsabfall über dem eingeschalteten MOSFET (Uds = Uf) abhängig von seinem Drainstrom, von seiner Steuerspannung Ugs und der Kristalltemperatur (Temp.).

$$\text{Uds = f(Id, Ugs, Temp.)}$$

Die Steuerspannung Ugs wird durch den Treiber vorgegeben und ist daher bekannt. Durch Erfassen der Temperatur der Halbleiterschalter, was ohnehin empfehlenswert ist und aus Betriebssicherheitsgründen geschehen sollte, ist es möglich, den tatsächlichen Stromfluß über die Drain- Source- Strecke bei Einsatz von MOSFET, bzw. Kollektor- Emitter- Strecke bei Einsatz von IGBT, zu ermitteln.

Die Kompensation des Temperatureinflusses auf den Spannungsabfall über den Halbleiterschalter kann durch ein einfaches analoges Netzwerk oder durch den hier beispielhaft angewendeten Microcontroller erfolgen. Durch die erfinderische Lösung kann eine Überwachungsschaltung auf sehr kostengünstige Weise realisiert werden.

## Patentansprüche

1. Verfahren zur Stromüberwachung für Halbleiterschalter, in Halb- oder Vollbrücken vorzugsweise in Schaltungsanordnungen der Leistungselektronik, bestehend aus Schaltern in TOP- und BOTTOM- Positionen (MOS1, MOS2, MOS3, MOS4) insbesondere bei Einsatz von MOSFET-oder IGBT-Schaltern,
   **dadurch gekennzeichnet, dass**
   durch Wandlung der Flussspannungen Uftop aller Halbleiterschalter in TOP- Position (MOS1, MOS3) in von diesen Flussspannungen abgeleitete Ströme Ifptop und anschließende Rückwandlung dieser Ströme Ifptop in Spannungen Ufptop auf der BOTTOM- Bezugsspannungs-Potentialebene GND und analoge Disjunktion dieser Spannungen Ufptop mit den von den Flussspannungen der BOTTOM- Schalter (MOS2, MOS4) Ufbot abgeleiteten Spannungen Ufpbot, so dass das analoge Disjunktionsprodukt eine Spannung U(R11) ergibt, die wiederum von der Flussspannung desjenigen Halbleiterschalters abgeleitet ist, der die höchste Flussspannung in der zu überwachenden Anordnung aufweist.

2. Verfahren nach Anspruch 1, **dadurch gekennzeichnet, dass**
   die Wandlung der Flussspannung Uftop eines Halbleiters in TOP- Position in einen von dieser Flussspannung abgeleiteten Strom Ifptop und Rückwandlung dieses Stromes in eine Spannung Ufptop auf der BOTTOM- Bezugsspannungs- Potentialebene durchgeführt wird.

3. Verfahren nach Anspruch 1, **dadurch gekennzeichnet, dass**
   auf der Grundlage des proportionalen Verhaltens von Ufptop zu Uftop und Ufpbot zu Ufbot unter Berücksichtigung von Steuerspannung und Kristalltemperatur der Halbleiterschalter sowie Auswertung von U(R11) der maximale Schalterstrom in der zu überwachenden Anordnung ermittelt wird.

4. Verfahren nach Ansprüche 1 oder 2, **dadurch gekennzeichnet, dass**
   die Wandlung der Flussspannung Uftop des jeweiligen TOP- Schalters in einen dazu proportionalen Strom Ifptop durch das Steuersignal dieses TOP- Schalters gelenkt wird, so dass der Strom Ifptop ausschließlich ein Abbild des Spannungsabfalles über diesem TOP- Schalter in dessen eingeschaltetem Zustand ist.

5. Verfahren nach Ansprüche 1 oder 2, **dadurch gekennzeichnet, dass**
   die Ableitung von Ufpbot aus der Flussspannung Ufbot des jeweiligen Halbleiterschalters in BOTTOM- Position MOS2 (bzw. MOS4) durch das Steuersignal dieses BOTTOM-Schalters gelenkt wird, so dass die Spannung Ufpbot ein Abbild des Spannungsabfalles über diesem BOTTOM- Schalter ausschließlich in dessen eingeschaltetem Zustand ist.

6. Vorrichtung zur Durchführung des Verfahrens nach Anspruch 1 zur Stromüberwachung von Halbleiterschalter in Halb- oder Vollbrücken vorzugsweise in Schaltungsanordnungen der Leitungselektronik, bestehend aus Schaltern in TOP- und BOTTOM- Position,
**dadurch gekennzeichnet, dass**
die Vorrichtung

- eine Wandelstruktur D1, R2, R3, Q1 (bzw. D4, R7, R8, Q2), die durch die Steuerspannung des TOP- Schalters MOS1 (bzw. MOS3) aktiviert wird, bestehend aus einer Parallelschaltung des Widerstandes R3 (bzw. R8) und der Emitter- Basis-Strecke des Transistors Q1 (bzw. Q2) mit der Drain- Source- Strecke des TOP-Schalters MOS1 (bzw. MOS3) und der Diode D1 (bzw. D4) zur Wandlung der Flussspannung Uftop in einen proportionalen Strom Ifptop,
- eine Abbildungsstruktur D2, D3, R4, R5 (bzw. D5, D6, R9, R10), die durch die Steuerspannung des BOTTOM-Schalters MOS2 (bzw. MOS4) aktiviert wird, bestehend aus einer Parallelschaltung der Diode D3 (bzw. D6) und des Widerstandes R11 mit der Diode D2 (bzw. D5) und der Drain- Source- Strecke des BOTTOM- Schalters.MOS2 (bzw. MOS4) zur Abbildung des Flussspannungsabfalls über dem BOTTOM Schalter MOS2 (bzw. MOS 4) auf den Widerstand R11,
- sowie eine analoge Disjunktion derart umfasst, dass
bei einem höheren Flussspannungsabfall über einem TOP-Schalter (MOS1, MOS3) verglichen mit dem Flussspannungsabfall über einem BOTTOM-Schalter (MOS2, MOS4) die Diode D3 bzw. D6 sperrt und über dem Widerstand R11 ein Abbild der Flussspannung des TOP- Schalters abfällt,
bei einem höheren Flussspannungsabfall über einem BOTTOM-Schalter (MOS2, MOS4) verglichen mit dem Flussspannungsabfall über einem TOP-Schalter (MOS1, MOS3) die Diode D3 bzw. D6 leitend wird und somit ein Strom zu Ifptop addiert wird und damit über dem Widerstand R11 ein Abbild der Flussspannung des BOTTOM- Schalters abfällt.

7. Vorrichtung nach Anspruch 6, **dadurch gekennzeichnet, dass**
die Schaltstruktur für die Wandlung der Flussspannung Uftop in Ifptop des entsprechenden Halbleiterschalters MOS1 (bzw. MOS3) in TOP- Position eine erste Diode D1 (bzw. D4) aufweist, die im Sperrzustand des jeweiligen TOP- Schalters die im allgemeinen vergleichsweise hohe Sperrspannung über diesem TOP- Schalter von der Wandlungsstruktur trennt.

8. Vorrichtung nach Anspruch 6, **dadurch gekennzeichnet, dass**
die Schaltstruktur für die Wandlung der Flussspannungen Uftop in Ifptop der entsprechenden TOP- Schalter MOS1 (bzw. MOS3) einen Transistor Q1 (bzw. Q2) mit einem äußeren Emitterwiderstand R3 (bzw. R8) aufweist, der so verschaltet ist, dass der Spannungsabfall über seiner Steuerstrecke die Flussspannung der ersten Diode D1 (bzw. D4) kompensiert und der Spannungsabfall über den entsprechenden äußeren Emitterwiderstand R3 (bzw. R8) gleich dem Flussspannungsabfall über diesem TOP-Schalter selbst MOS1 (bzw. MOS3) ist.

9. Vorrichtung nach Anspruch 6, **dadurch gekennzeichnet, dass**
der Transistor Q1 (bzw. Q2) den in dem Emitterwiderstand R3 (bzw. R8) fließenden Strom Ifptop aufgrund seines Stromquellencharakters weitgehend unabhängig vom Source- Potential des TOP- Schalters MOS1 (bzw. MOS3) in den Widerstand R11 einprägt, so dass der Spannungsabfall an diesem Widerstand R11 proportional zur Flussspannung dieses TOP- Schalters MOS1 (bzw. MOS3) ist.

10. Vorrichtung nach Anspruch 6, **dadurch gekennzeichnet, dass**
die Schaltstruktur für die Ableitung der Spannung Ufpbot aus Ufbot, die ein Abbild der Flussspannung des entsprechenden Leistungsschalters in BOTTOM- Position ist, eine zweite Diode D2 (bzw. D5) aufweist, die im Sperrzustand des BOTTOM- Schalters MOS2 (bzw. MOS4) die im allgemeinen hohe Sperrspannung über diesem Halbleiterschalter abtrennt.

11. Vorrichtung nach Anspruch 10, **dadurch gekennzeichnet, dass**
die Schaltstruktur für die Ableitung der Spannung Ufpbot aus Ufbot, die ein Abbild der Flussspannung des Leistungsschalters in BOTTOM- Position ist, eine dritte Diode D3 (bzw. D6) enthält, welche die Flussspannung der zweiten Diode D2 (bzw. D5) kompensiert und gleichzeitig der analogen Disjunktion der von den Flussspannungen der Leistungsschalter in TOP- Position abgeleiteten Spannungen Ufptop mit den Flussspannungen der Leistungsschalter in BOTTOM- Position abgeleiteten Spannungen dient.

**Claims**

1.  A method for current monitoring of semiconductor switches in half bridges or full bridges, in particular in circuit arrangements of power control systems, consisting of switches in TOP and BOTTOM positions (MOS1, MOS2, MOS3, MOS4), in particular if MOSFET or integrated-gate bipolar transistor switches are used, **characterized in that** by converting the voltages Uftop of all semiconductor switches in TOP positions (MOS1, MOS3) into currents Ifptop shunted from these voltages, and subsequently reconverting these currents Ifptop into voltages Ufptop on the BOTTOM reference voltage potential level GND, and analogous disjunction of these voltages Ufptop with the voltages Ufpbot shunted from the voltages of the BOTTOM switches (MOS2, MOS4), so that the analogous disjunction product results in a voltage U(R11) which is also shunted from the voltage of that semiconductor switch which has the highest voltage in the arrangement to be monitored.

2.  A method according to claim 1, **characterized in that** the conversion of the voltage Uftop of a semiconductor in TOP position into a current Ifptop shunted from this voltage and reconversion of this current into a voltage Ufptop on the BOTTOM reference voltage potential level is performed.

3.  A method according to claim 1, **characterized in that** the maximum switching current is determined in the arrangement to be monitored on the basis of the proportional behaviour Ufptop to Uftop and Ufpbot to Ufbot under consideration of the control voltage and crystal temperature of the semiconductor switches and the evalutation of U(R11).

4.  A method according to claim 1 or 2, **characterized in that** the conversion of the voltage Uftop of the respective TOP switch is deflected into a current Ifptop which is proportional thereto by the control signal of this TOP switch, so that the current Ifptop represents exclusively an image of the voltage drop across this TOP switch when this switch is switched on.

5.  A method according to claim 1 or 2, **characterized in that** the shunting of Ufpbot from the voltage Ufbot of the respective semiconductor switch in BOTTOM position MOS2 (or MOS4) is deflected by the control signal of this BOTTOM switch so that the voltage Ufpbot is an image of the voltage drop across this BOTTOM switch exclusively when this switch is switched on.

6.  Device for carrying out the method according to claim 1 for current monitoring of semiconductor switches in half bridges or full bridges, in particular in circuit arrangements of power control systems, consisting of switches in TOP position and in BOTTOM position, **characterized in that** the device comprises:

    •   a converter structure D1, R2, R3, Q1 (or D4, R7, R8, Q2), which is activated by the control voltage of the TOP switch MOS1 (or MOS3), consisting of a parallel connection of the resistor R3 (or R8) and the emitter-base path of the transistor Q1 (or Q2) with the drain-source path of the TOP switch MOS1 (or MOS3) and the diode D1 (or D4) for converting the voltage Uftop into a proportional current Ifptop,

    •   an imaging structure D2, D3, R4, R5 (or D5, D6, R9, R10), which is activated by the control voltage of the BOTTOM switch MOS2 (or MOS4), consisting of a parallel connection of the diode D3 (or D6) and the resistor R11 with the diode D2 (or D5) and the drain-source path of the BOTTOM switch MOS2 (or MOS4) for imaging the voltage drop across the BOTTOM switch MOS2 (or MOS4) onto the resistor R11 and

    •   an analogous disjunction so that the diode D3 or D6 blocks and a voltage image of the voltage of the TOP switch shows a drop across the resistor R11 when a higher voltage drop across a TOP switch (MOS1, MOS3) occurs as compared with the voltage drop across a BOTTOM switch (MOS2, MOS4), the diode D3 or D6 becomes conductive and thus a current is added to Ifptop and a a voltage image of the voltage of the BOTTOM switch shows a drop across the resistor R11 when a higher voltage drop across a BOTTOM switch (MOS2, MOS4) occurs as compared with the voltage drop across a TOP switch (MOS1, MOS3).

7.  Device according to claim 6, **characterized in that** the switching structure for the conversion of the voltage Uftop into Ifptop of the corresponding semiconductor switch MOS1 (or MOS3) in TOP position has a first diode D1 (or D4) which separates the generally comparably high cut-off voltage across this TOP switch from the converting structure when the respective TOP switch is blocked.

8.  Device according to claim 6, **characterized in that** the switching structure for the conversion of the voltages Uftop into Ifptop of the corresponding TOP switches MOS1 (or MOS3) comprises a resistor Q1 (or Q2) with an external emitter resistor R3 (or R8) which is wired such that the voltage drop across its control path compensates the voltage of the first diode D1 (or D4) and the voltage drop across the corresponding external emitter resistor R3 (or R8) is equal to the voltage drop across this TOP switch itself MOS1 (or MOS3).

9.  Device according to claim 6, **characterized in that** the transistor Q1 (or Q2) impresses upon the resistor R11 the current Ifptop flowing in the emitter resistor R3 (or R8), due to its current source character, to a great extent independent of the source potential of the TOP switch MOS1 (or MOS3), so that the voltage drop at this resistor R11 is proportional to the voltage of this TOP switch MOS1 (or MOS3).

10. Device according to claim 6, **characterized in that** the switching structure for shunting the voltage Ufpbot from Ufbot, which is an image of the voltage of the corresponding power switch in BOTTOM position, comprises a second diode D2 (or D5) separating in the blocked condition of the BOTTOM switch MOS2 (or MOS4) the generally high cut-off voltage across this semiconductor switch.

11. Device according to claim 10, **characterized in that** the switching structure for shunting the voltage Ufpbot from Ufbot, which is an image of the voltage of the power switch in BOTTOM position, contains a third diode D3 (or D6) compensating the voltage of the second diode D2 (or D5) and simultaneously serves for an analogous disjunction of the voltages Ufptop shunted from the voltages of the power switches in TOP position with the voltages of the power switches in BOTTOM position.

**Revendications**

1.  Procédé de surveillance de courant pour interrupteur semi-conducteur, dans des demi-ponts ou dans des ponts intégraux de préférence dans des circuits de l'électronique de puissance, constitués d'interrupteurs en positions TOP et BOTTOM (MOS1, MOS2, MOS3, MOS4), notamment lors de l'utilisation d'interrupteurs MOSFET ou IGBT, **caractérisé par** la conversion des tensions de flux Uftop de tous les interrupteurs semi-conducteurs en position TOP (MOS1, MOS3) en courants Ifptop déduits de ces tensions de flux et par la reconversion consécutive de ces courants Ifptop en tensions Ufptop au niveau de potentiels de tension de référence BOTTOM GND et par la disjonction analogique de ces tensions Ufptop avec les tensions Ufpbot déduites des tensions de flux Ufbot des interrupteurs BOTTOM (MOS2, MOS4), de telle sorte que le produit de disjonction analogique donne une tension U(R11) qui est elle-même déduite de la tension de flux de celui des interrupteurs semi-conducteurs qui a la plus grande tension de flux dans le dispositif à surveiller.

2.  Procédé selon la revendication 1, **caractérisé en ce qu'**on effectue la conversion de la tension de flux Uftop d'un semi-conducteur en position TOP en un courant Ifptop déduit de cette tension de flux et la reconversion de ce courant en une tension Ufptop au niveau de potentiels de tension de référence BOTTOM.

3.  Procédé selon la revendication 1, **caractérisé en ce que**, sur la base du comportement proportionnel de Ufptop à Uftop et de Ufpbot à Ufbot, on détermine, en tenant compte de la tension de commande et de la température de cristal des interrupteurs semi-conducteurs ainsi qu'en évaluant U(R11), le courant maximal d'interrupteur dans le dispositif à surveiller.

4.  Procédé selon les revendications 1 ou 2, **caractérisé en ce que** la conversion de la tension de flux Uftop de l'interrupteur TOP respectif en un courant Ifptop proportionnel à celle-ci est dirigée par le signal de commande de cet interrupteur TOP, de telle sorte que le courant Ifptop est exclusivement une reproduction de la chute de tension à cet interrupteur TOP dans son état enclenché.

5.  Procédé selon les revendications 1 ou 2, **caractérisé en ce que** la déduction de Ufpbot à partir de la tension de flux Ufbot de l'interrupteur semi-conducteur respectif en position BOTTOM MOS2 (ou MOS4) est dirigée par le signal de commande de cet interrupteur BOTTOM, de telle sorte que la tension Ufpbot est une représentation de la chute de tension à cet interrupteur BOTTOM exclusivement dans son état enclenché.

**6.** Dispositif pour la mise en oeuvre du procédé selon la revendication 1 pour la surveillance de courant d'interrupteurs semi-conducteurs dans des demi-ponts ou dans des ponts intégraux de préférence dans des circuits de l'électronique de puissance, constitués d'interrupteurs en position TOP et BOTTOM,

> **caractérisé en ce que**
>  le dispositif comprend

- • une structure de conversion D1, R2, R3, Q1 (ou D4, R7, R8, Q2), qui est activée par la tension de commande de l'interrupteur TOP MOS1 (ou MOS3), constituée d'un branchement parallèle de la résistance R3 (ou R8) et de la voie émetteur-base du transistor Q1 (ou Q2) avec la voie drain-source de l'interrupteur TOP MOS1 (ou MOS3) et la diode D1 (ou D4) pour la conversion de la tension de flux Uftop en un courant proportionnel Ifptop,
- • une structure de reproduction D2, D3, R4, R5 (ou D5, D6, R9, R10), qui est activée par la tension de commande de l'interrupteur BOTTOM MOS2 (ou MOS4), constituée d'un branchement parallèle de la diode D3 (ou D6) et de la résistance R11 avec la diode D2 (ou D5) et la voie drain-source de l'interrupteur BOTTOM MOS2 (ou MOS4) pour la reproduction de la chute de tension de flux à l'interrupteur BOTTOM MOS2 (ou MOS4) sur la résistance R11,
- • ainsi qu'une disjonction analogique de telle sorte que pour une chute de tension de flux plus grande à l'interrupteur TOP (MOS1, MOS3) comparée à la chute de tension de flux à l'interrupteur BOTTOM (MOS2, MOS4), la diode D3 ou D6 est bloquante et une reproduction de la tension de flux de l'interrupteur TOP chute à la résistance R11,

pour une chute de tension de flux plus grande à l'interrupteur BOTTOM (MOS2, MOS4) comparée à la chute de tension de flux à l'interrupteur TOP (MOS1, MOS3), la diode D3 ou D6 est conductrice et un courant est donc additionné en Ifptop et une reproduction de la tension de flux de l'interrupteur BOTTOM chute à la résistance R11.

**7.** Dispositif selon la revendication 6, **caractérisé en ce que** la structure de branchement pour la conversion de la tension de flux Uftop en Ifptop de l'interrupteur semi-conducteur correspondant MOS1 (ou MOS3) en position TOP comporte une première diode D1 (ou D4) qui, à l'état bloquant de l'interrupteur TOP respectif, sépare de la structure de conversion la tension de blocage en général comparativement élevée à cet interrupteur TOP.

**8.** Dispositif selon la revendication 6, **caractérisé en ce que** la structure de branchement pour la conversion des tensions de flux Uftop en Ifptop des interrupteurs TOP correspondants MOS1 (ou MOS3) comporte un transistor Q1 (ou Q2) avec une résistance d'émetteur extérieure R3 (ou R8) qui est branché de telle sorte que la chute de tension à sa voie de commande compense la tension de flux de la première diode D1 (ou D4) et la chute de tension à la résistance d'émetteur extérieure correspondante R3 (ou R8) est égale à la chute de tension de flux à cet interrupteur TOP lui-même MOS1 (ou MOS3).

**9.** Dispositif selon la revendication 6, **caractérisé en ce que** le transistor Q1 (ou Q2) imprime le courant Ifptop, passant dans la résistance d'émetteur R3 (ou R8), en raison de son caractère de source de courant et largement indépendamment du potentiel de source de l'interrupteur TOP MOS1 (ou MOS3), dans la résistance R11 de telle sorte que la chute de tension à cette résistance R11 est proportionnelle à la tension de flux de cet interrupteur TOP MOS1 (ou MOS3).

**10.** Dispositif selon la revendication 6, **caractérisé en ce que** la structure de branchement pour la déduction de la tension Ufpbot à partir de Ufbot, qui est une reproduction de la tension de flux de l'interrupteur de puissance correspondant en position BOTTOM, comporte une deuxième diode D2 (ou D5) qui, à l'état bloquant de l'interrupteur BOTTOM MOS2 (ou MOS4), coupe la tension de blocage en général élevée à cet interrupteur semi-conducteur.

**11.** Dispositif selon la revendication 10, **caractérisé en ce que** la structure de branchement pour la déduction de la tension Ufpbot à partir de Ufbot, qui est une reproduction de la tension de flux de l'interrupteur de puissance en position BOTTOM, contient une troisième diode D3 (ou D6) qui compense la tension de flux de la deuxième diode D2 (ou D5) et qui sert en même temps à la disjonction analogique des tensions Ufptop, déduites des tensions de flux des interrupteurs de puissance en position TOP, avec les tensions déduites des tensions de flux des interrupteurs de puissance en position BOTTOM.

Fig. 1

Fig. 2

Fig. 3

EP 0 844 720 B1

U(R11) = MAX (Ufptop, Ufpbot)

Fig. 4